# EUROPÄISCHE PATENTSCHRIFT

(11) **EP 2 583 540 B1**
(45) Veröffentlichungstag und Bekanntmachung des Hinweises auf die Patenterteilung: **15.10.2014**
(21) Anmeldenummer: 11723474.0
(22) Anmeldetag: 06.06.2011
(51) Int. Cl.: H05K 3/32, H01R 43/02

(54) **VERFAHREN ZUR HERSTELLUNG EINER ELEKTRISCHEN VERBINDUNG SOWIE ELEKTRISCHE VERBINDUNG**
METHOD FOR MANUFACTURING AN ELECTRICAL CONNECTION AND ELCETRICAL CONNECTION
PROCÉDÉ DE FABRICATION D'UNE CONNECTION ÉLECTRIQUE ET CONNECTEUR ÉLECTRIQUE

(30) Priorität: 15.06.2010 DE 102010030070
(43) Veröffentlichungstag der Anmeldung: 24.04.2013
(73) Patentinhaber: Robert Bosch GmbH, 70442 Stuttgart (DE)
(72) Erfinder: ARENS, Christian, 70806 Kornwestheim (DE)
(86) Internationale Anmeldenummer: PCT/EP2011/059296
(87) Internationale Veröffentlichungsnummer: WO 2011/157585

(56) Entgegenhaltungen:
- EP-B1- 1 155 602
- DE-C2- 10 036 900
- JP-A- 2010 086 929

## Beschreibung

### Stand der Technik

Die Bedeutung elektronischer Systeme in Kraftfahrzeugen nimmt unter anderem aufgrund der ständig steigenden Anforderungen an die Verringerung des Schadstoffausstoßes und des Kraftstoffverbrauchs der Verbrennungsmotoren sowie einem beständig wachsenden Komfortbedürfnis der relevanten Käuferkreise stetig zu. Hierbei bereitet die Sicherstellung einer verlässlichen elektrischen Verbindung zwischen den elektronischen Komponenten unter allen im täglichen Kraftfahrbetrieb auftretenden Umgebungseinflüssen nach wie vor erhebliche Schwierigkeiten. Beispiele für Umgebungseinflüsse, die schädlich auf die Funktion der elektronischen Systemkomponenten und deren elektrische Verbindungen wirken, sind Temperaturschwankungen, Feuchtigkeit, hohe Beschleunigungen und Verzögerungen sowie chemisch aggressive Fluide. In modernen Kraftfahrzeugen ist es demzufolge erforderlich, eine Vielzahl elektronischer Steuergeräte mit einer Vielzahl von Gebern und Aktuatoren sowie mit der übrigen im Fahrzeug vorhandenen allgemeinen elektrischen Verbindungstechnik (so genannte "AVT") zu kontaktieren. Die hierfür notwendigen elektrischen Verbindungen werden vielfach mittels flexibler Flachleitungen ausgeführt. Insbesondere sicherheitsrelevante Komponenten, wie zum Beispiel elektronische Brems- und Fahrerassistenzsysteme, elektronische Motor- und Getriebesteuerungssysteme müssen jedoch auch unter extremen Umgebungsbedingungen und in allen denkbaren Betriebssituationen des Fahrzeugs absolut verlässlich funktionieren, so dass der Kontaktsicherheit der elektrischen Verbindungen ein besonderes Gewicht zukommt.

Aus der DE 100 36 900 C2 sind beispielsweise ein Verfahren zur Kontaktierung einer flexiblen Leiterplatte mit einem metallischen Kontaktpartner sowie eine Anordnung aus einer flexiblen Leiterplatte und dem Kontaktpartner bekannt.

Die flexible Leiterplatte ("FPC" oder "Flexible Printed Circuit") ist in bekannter Weise mit einer Vielzahl von bevorzugt parallel und gleichmäßig beabstandet zueinander verlaufenden Kupferleiterbahnen gebildet, die beidseitig mit einer aufgeklebten Isolierschicht kaschiert sind. Im Bereich der herzustellenden elektrischen Kontaktierung wird die Isolierschicht auf einer Seite der Flachleitung entfernt bzw. eine Ausnehmung eingebracht, so dass in dieser eine Zugangsöffnung mit einer beispielsweise kreisförmigen Geometrie entsteht. Hierbei wird ein Durchmesser der Zugangsöffnung bevorzugt geringfügig größer als ein Durchmesser eines metallischen Kontaktpartners gewählt. Anschließend wird eine plane Stirnfläche des mit der Kupferleiterbahn leitend zu verbindenden Kontaktpartners im Idealfall vollflächig auf die Unterseite der Kupferleiterbahn aufgesetzt. Die Schaffung der leitfähigen Verbindung erfolgt in einem letzten Schritt durch den Einsatz von gepulster Laserstrahlung, die von oben durch die noch vorhandene Isolierschicht dringt, wodurch die Kupferleiterbahn mit der Stirnfläche des metallischen Kontaktpartners verschweißt oder verlötet wird. Ein Nachteil dieses Verfahrens liegt darin, dass sich die vertikale Ausrichtung der metallischen Kontaktpartner in Relation zu den zugehörigen Kupferleiterbahnen schwierig gestaltet.

Die EP 1 155 602 B1 betrifft ein elektrisches Verbindungsverfahren und eine Verbindungsstelle. Eine flexible Leiterplatte wird im Bereich einer zu schaffenden Kontaktstelle zunächst beidseitig von den Isolierschichten befreit ("abisoliert"), so dass mindestens eine Kupferleiterbahn in dieser Zone frei liegt und beidseitig eine Zugangsöffnung entsteht. Im Fall von kreisförmigen Zugangsöffnungen ist deren Durchmesser so bemessen, dass dieser geringfügig größer ist als ein Durchmesser eines exemplarisch ebenfalls zylindrischen metallischen Kontaktpartners, insbesondere eines Kontaktstiftes. Optional wird die obere Zugangsöffnung noch mit einer Korrosionsschutzschicht versiegelt. In einem weiteren Verfahrensschritt wird die plane Stirnfläche des Kontaktpartners von unten an die freiliegende Kupferleiterbahn herangeführt, bis diese im Idealfall vollflächig an der Leiterbahn anliegt. Zur Herstellung der elektrischen Verbindung wird dann die obere Öffnung in der Isolierschicht in bekannter Weise der Einwirkung eines Laserstrahls geeigneter Intensität und Dauer ausgesetzt, wodurch die Kupferleiterbahn in diesem Bereich mit der Stirnseite des metallischen Kontaktpartners unlösbar verschweißt oder verlötet wird.

Auch bei diesem Verfahren muss vor dem Fügeprozess eine präzise Ausrichtung der Stirnflächen der metallischen Kontaktpartner zu den Kupferleiterbahnen erfolgen. Dies erfordert insbesondere bei den heutzutage geringen Abmessungen der Kupferleiterbahnen und den hiermit zu verbindenden Kontaktpartnern, die in der Regel nur wenige zehntel Millimeter betragen, einen hohen fertigungstechnischen Aufwand.

### Offenbarung der Erfindung

Es wird zunächst ein Verfahren zur Herstellung einer elektrischen Verbindung zwischen einer flexiblen Flachleitung, die auch als Folienleiter bezeichnet wird, mit einer Vielzahl von Leiterbahnen, die zwischen zwei Isolierschichten angeordnet sind, und mindestens einem metallischen Kontaktpartner mit einer Stirnfläche, insbesondere mindestens einem Kontaktstift offenbart.

In einem ersten Verfahrensschritt wird im Bereich mindestens einer Fügezone mindestens eine Ausnehmung in eine Isolierschicht sowie die darunter liegende Klebeschicht der flexiblen Flachleitung eingebracht. Alternativ kann die Isolierschicht im Bereich der Fügezone auch vollständig von der Leiterbahn entfernt werden. Vorzugsweise wird die Ausnehmung in einem Endbereich der Flachleitung eingebracht bzw. die Isolierschicht in diesem Bereich vollständig entfernt. Im Unterschied zum Stand der Technik wird anschließend auf die gegenüberliegende Isolierschicht im Bereich der Fügezone ein für Laserstrahlung durchgängiges Versteifungselement zur mechanischen Stabilisierung und zur Vereinfachung des Ausrichtprozesses vor dem Fügeprozess aufgebracht, insbesondere mittels einer Klebeschicht aufgeklebt. In einem weiteren Verfahrensschritt wird die mindestens eine Leiterbahn mittels des Versteifungselements in Relation zu den Kontaktpartnern präzise ausgerichtet. Hierbei werden die ebenen Stirnflächen der Kontaktpartner möglichst vollflächig mit den Unterseiten der Kupferleiterbahnen in Anlage gebracht, um einen einwandfreien elektrischen Kontakt mit zugleich optimalen mechanischen Eigenschaften zu schaffen.

In einem letzten Verfahrensschritt werden die metallischen Kontaktpartner mit den Kupferleiterbahnen durch von oben durch das Verstärkungselement sowie die verbliebene Isolierschicht hindurch tretende, gepulste Laserstrahlung thermisch gefügt, insbesondere verschweißt oder verlötet. Hierdurch entsteht eine Vielzahl von elektrischen Kontakten zwischen den metallischen Kontaktpartnern und den zugehörigen Kupferleiterbahnen der flexiblen Flachleitung. Die solchermaßen hergestellten elektrischen Verbindungs- bzw. Kontaktpunkte verfügen über eine hohe mechanische Belastbarkeit.

Das Versteifungselement ist bevorzugt plattenförmig, insbesondere quaderförmig, ausgestaltet und wird mittels eines gleichfalls für die eingesetzte Laserstrahlung durchlässigen Acryl- oder Epoxidklebers auf die in der Fügezone verbliebene Isolierschicht aufgeklebt. Nach der Beendigung des Verfahrens verbleibt das Versteifungselement auf der flexiblen Flachleitung.

Das verfahrensgemäß vorgesehene Versteifungselement ermöglicht die gleichzeitige und vor allem präzise Ausrichtung aller freigelegten Kupferleiterbahnen in Relation zu den hiermit thermisch zu fügenden metallischen Kontaktpartnern, was zu elektrischen Verbindungsstellen mit optimalen elektrischen und mechanischen Eigenschaften führt. Darüber hinaus vereinfacht das aufgeklebte Versteifungselement die Automatisierbarkeit des Verfahrens erheblich.

Darüber hinaus wird eine insbesondere verfahrensgemäß hergestellte elektrische Verbindung zwischen einer flexiblen Flachleitung mit einer Vielzahl von Leiterbahnen, die zwischen zwei Isolierschichten angeordnet sind, und mindestens einem metallischen Kontaktpartner mit einer Stirnfläche, insbesondere mindestens einem Kontaktstift, offenbart. Erfindungsgemäß weist eine Isolierschicht im Bereich mindestens einer Fügezone eine Ausnehmung auf und mindestens eine Leiterbahn ist in der mindestens einen Fügezone mit dem mindestens einen metallischen Kontaktpartner zur Herstellung einer elektrischen Verbindung thermisch gefügt, insbesondere laserverschweißt oder laserverlötet, und im Bereich der Fügezonen ist zumindest ein Versteifungselement mit der gegenüberliegenden, verbliebenen Isolierschicht verbunden.

Mittels des Versteifungselements können unter anderem die in der flexiblen Leitung enthaltenen Kupferleiterbahnen auf einfache Art und Weise in Relation zu den metallischen Kontaktpartnern ausgerichtet werden. Damit lässt sich die elektrische Verbindung mit optimalen elektrischen und mechanischen Eigenschaften vor allem prozesssicher und fertigungstechnisch auf einfache Art und Weise herstellen. Darüber hinaus bildet das auf die flexible Flachleitung aufgeklebte Versteifungselement nach der Herstellung der elektrischen Verbindung einen wirksamen Schutz gegenüber mechanischen Beschädigungen der Flachleitung in diesem Bereich.

### Kurze Beschreibung der Zeichnungen

Anhand der Zeichnungen soll die Erfindung nachstehend näher erläutert werden.

Es zeigen:
- Figur 1: eine Querschnittsdarstellung durch eine verfahrensgemäß hergestellte elektrische Verbindung;
- Figur 2: einen Schnitt durch die elektrische Verbindung entlang der Schnittlinie II-II in der Figur 1; und
- Figur 3: eine Schnittdarstellung quer zur Schnittlinie II-II in der Figur 1 bzw. entlang der Schnittlinie III-III in der Figur 2.

### Ausführungsformen

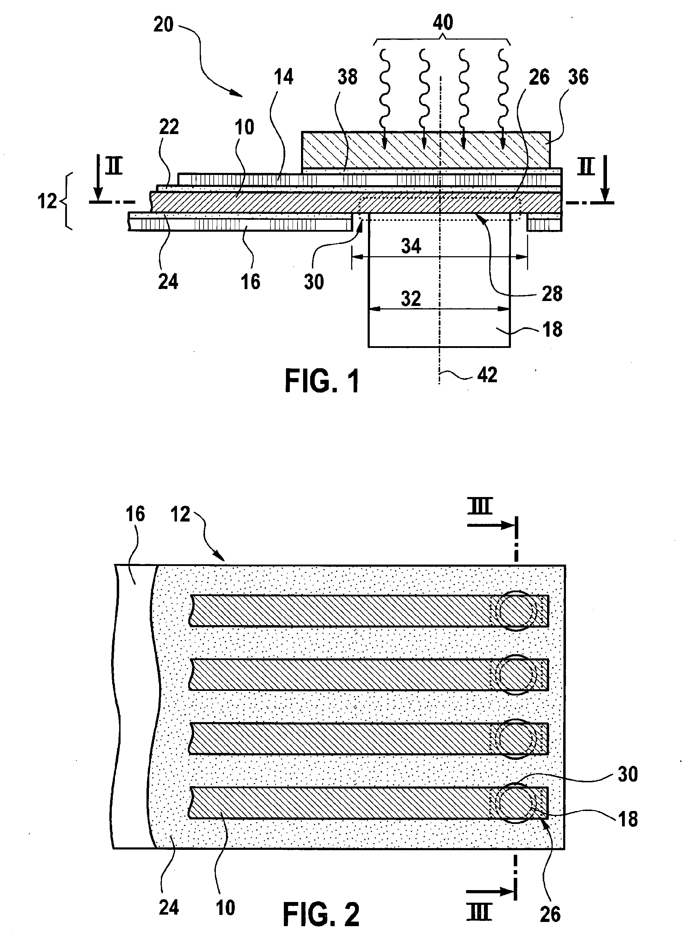

Anhand der Figur 1 soll zunächst eine erfindungsgemäße elektrische Verbindung näher erläutert werden.

Zwischen einer Leiterbahn 10 einer flexiblen Flachleitung 12, die beidseitig mit zwei Isolierschichten 14, 16 kaschiert ist, und einem metallischen Kontaktpartner 18 besteht eine elektrisch leitende Verbindung 20. Die Leiterbahn 10 ist bevorzugt mit einer Kupferlegierung oder reinem Kupfer gebildet, während die Isolierschichten 14, 16 mit einer Polyimid- oder einer Polyesterfolie hergestellt sind, die mittels der Klebeschichten 22, 24 mit der Leiterbahn 10 in bekannter Weise vollschichtig verklebt sind. Eine Materialstärke der Isolierschichten 14, 16 liegt im Allgemeinen in einem Bereich zwischen 10 µm und 100 µm, während die Leiterbahn 10 eine Materialstärke zwischen 20 µm und 200 µm aufweist. Die Klebeschichten 22,24 können jeweils mit einem Acryl- oder mit einem Epoxidkleber hergestellt sein.

Im Bereich einer Fügezone 26 ist die Leiterbahn 10 mit einer Stirnfläche 28 des metallischen Kontaktpartners 18 zur Herstellung der elektrischen Verbindung 10 thermisch gefügt. Im Bereich der Fügezone 26 weist die untere Isolierschicht 16 einschließlich der zugehörigen Klebeschicht 22 eine Ausnehmung 30 bzw. eine Aussparung auf, um den thermischen Fügeprozess zu ermöglichen. Alternativ können die Isolierschicht 16 und die Klebeschicht 24 im Bereich der Leiterbahn 10 auch vollständig entfernt werden. Soll die elektrische Kontaktierung auf der hiervon abgewandten Seite erfolgen, wird mit der Isolierschicht 14 sowie der zugehörigen Klebeschicht 22 entsprechend verfahren.

Bei dem in Figur 1 exemplarisch gezeigten Kontaktpartner 18 in der Form eines zylindrischen Kontaktstiftes mit einem Durchmesser 32 weist die in dieser Konstellation gleichfalls kreisrunde Ausnehmung 30 einen im Vergleich zum Durchmesser 32 geringfügig größeren Durchmesser 34 auf. Die Ausnehmung 30 bzw. die Ausnehmungen können bei der Herstellung einer Vielzahl von elektrischen Verbindungen in vorteilhafter Weise bereits während des Fertigungsprozesses der Leiterbahn 10 in die untere Isolierschicht 16 eingebracht, zum Beispiel eingestanzt werden. Um einen möglichst geringen Übergangswiderstand zu erzielen, sollte der Durchmesser 32 des Kontaktpartners in etwa einer nicht bezeichneten Breite der Leiterbahn 10 entsprechen. Alternativ kann die Ausnehmung 30 auch einer Kontur der Fügezone 26 folgen.

Auf der oberen Isolierschicht 14 ist im Bereich der Fügezone 26 erfindungsgemäß ein Versteifungselement 36 mittels einer Klebeschicht 38 aufgebracht. Das im Wesentlichen rechteckförmige Versteifungselement 36 erstreckt sich im Bereich der Fügezone 26 bzw. der Fügezonen quer zur Verlaufsrichtung der Leiterbahnen und verfügt über eine Breite, die bevorzugt mindestens einer Gesamtbreite der Flachleitung 12 entspricht. Durch das Versteifungselement 36 wird insbesondere die vertikale, parallel zur Zentralachse 42 erfolgende Positionierung der Stirnfläche 28 in Bezug zur Leiterbahn 10 erleichtert, was insbesondere bei einer Vielzahl von Leiterbahnen und den hiermit elektrisch zu verbindenden Kontaktpartnern von zentraler Bedeutung ist, da es zur Erzielung einer elektrischen Verbindung 20 mit optimalen Eigenschaften notwendig ist, während des thermischen Fügeprozesses eine möglichst vollflächige Anlage der Stirnfläche 28 auf der Leiterbahn 10 zu erzielen. Infolge des Versteifungselementes 36 können darüber hinaus die Leiterbahnen 10 mit einer exakt vordefinierten mechanischen Anpresskraft an die Stirnflächen der zugehörigen Kontaktpartner 28 angedrückt werden. Das Versteifungselement 36 muss sich nicht notwendigerweise über die gesamte Breite der flexiblen Flachleitung 12 erstrecken. Es kann vorteilhaft sein, auch nur einen Teil der Breite der flexiblen Flachleitung 11 zu versteifen, so zum Beispiel dann, wenn nur ein Teil kontaktiert werden muss, bzw. der verbleibende Teil der flexiblen Flachleitung 12 flexible Eigenschaften aufweisen soll. Eine Streckung des Versteifungselementes 36 über lediglich einen Teil der flexiblen Flachleitung 12 kann auch dann vorteilhaft sein, wenn zum Beispiel die gesamte Breite der flexiblen Flachleitung12 kontaktiert werden soll, jedoch in zwei Ebenen.

Der eigentliche Fügeprozesses erfolgt durch die Einkopplung von Laserstrahlung 40, die sowohl das Versteifungselement 36 als auch die Klebeschicht 38 sowie die darunter befindliche obere Isolierschicht 16 durchsetzt, wodurch die Leiterbahn 10 mit der Stirnfläche 28 des metallischen Kontaktpartners 18 verschweißt oder verlötet wird. Im Hinblick auf das für die Bildung der Klebeschicht 38 eingesetzte Kunststoffmaterial bestehen keine erhöhten mechanischen Anforderungen, es muss jedoch eine ausreichende Durchlässigkeit für die Laserstrahlung 40 gegeben sein. Das plattenförmige Versteifungselement 36 kann beispielsweise mit Acrylglas oder mit einem transparenten Polykarbonat gebildet sein. Die Klebeschicht 38 des Versteifungselements 36 kann mit demselben Material wie die Klebeschichten 22, 24 hergestellt sein.

Die Figur 2 illustriert eine Schnittdarstellung durch die elektrische Verbindung 20 entlang der Schnittlinie II-II in der Figur 1.

Die Leiterbahn 10 der Flachleitung 12 ist in einer Fügezone 26 mit dem Kontaktpartner 18 thermisch verbunden, insbesondere durch Löten oder Schweißen mit diesem zusammen gefügt und hierdurch elektrisch kontaktiert. Dasselbe gilt für die weiteren drei nicht bezeichneten Leiterbahnen in der Figur 2, die gleichmäßig parallel beabstandet zur Leiterbahn 10 verlaufen sowie den zugeordneten Kontaktpartnern. Die untere Isolierschicht 16 ist mittels der unteren Klebeschicht 24 mit der Leiterbahn 10 und den übrigen nicht bezeichneten Leiterbahnen verbunden. Darüber hinaus ist der Kontaktpartner 18 von der Ausnehmung 30 in der Isolierschicht 16 bzw. der Klebeschicht 24 umgeben. Dasselbe gilt für die übrigen nicht mit Bezugsziffern versehenen metallischen Kontaktpartner und den zugeordneten, hier kreisförmigen Ausnehmungen. Zwischen den Kontaktpartnern und den Ausnehmungen bestehende Spalte können nach der Beendigung des thermischen Fügeverfahrens erforderlichenfalls mit einer geeigneten Füllmasse versiegelt werden.

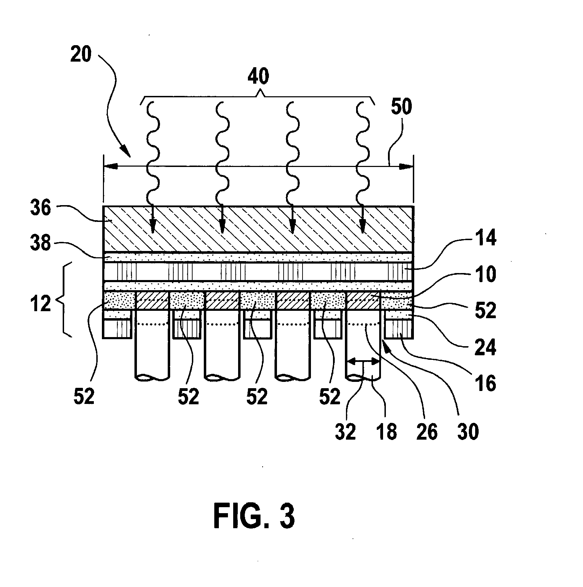

Die Figur 3 zeigt eine Schnittdarstellung quer zur Schnittlinie II-II in der Figur 1 bzw. entlang der Schnittlinie III-III in der Figur 2.

Der metallische Kontaktpartner 18 ist in der Fügezone 26 mit der Leiterbahn 10 der flexiblen Flachleitung 12 thermisch gefügt, was bevorzugt durch Laserschweißen oder Laserlöten erfolgt. Die Laserstrahlung 40 wird hierzu über geeignete Mittel, beispielsweise Glasfaserkabel, möglichst punktuell in die jeweilige Fügezone 26 geleitet. In entsprechender Weise sind die übrigen metallischen Kontaktpartner mit den weiteren Leiterbahnen thermisch gefügt und bilden in ihrer Gesamtheit die elektrische Verbindung 20. Um das einwandfreie thermische Fügen des Kontaktpartners 18 mit der Leiterbahn 10 zu ermöglichen, ist eine Ausnehmung 30 in die untere Isolierschicht 16 und die untere Klebeschicht 24 eingebracht. Hierbei ist der Durchmesser 32 des Kontaktpartners 18 geringfügig kleiner gewählt als der hier nicht bezeichnete Durchmesser der Ausnehmung 30 in der unteren Isolierschicht 16 und der unteren Klebeschicht 24, so dass ein umlaufender, nicht bezeichneter Spalt entsteht. Dieser Spalt und alle übrigen Spalte können nach der Beendigung des thermischen Fügeprozesses optional mit einer Füllmasse versiegelt werden. Eine Geometrie der Ausnehmung 30 korrespondiert bevorzugt mit der Querschnittsgeometrie des metallischen Kontaktpartners 18. Verfügen die metallischen Kontaktpartner abweichend von der in den Figuren gezeigten zylindrischen Formgebung beispielsweise über eine quaderförmige Form mit einer elliptischen, rechteckförmigen oder quadratischen Querschnittsgeometrie, so weisen die in die Isolierschicht 16 bzw. die Klebeschicht 24 einzubringenden Ausnehmungen dieselbe Geometrie, mit jedoch bevorzugt geringfügig vergrößerten Abmessungen, auf.

Auf der oberen Isolierschicht 14 befindet sich das mittels der Klebeschicht 38 befestigte Versteifungselement 36. Hierbei entspricht eine nicht bezeichnete Breite des näherungsweise quaderförmigen Versteifungselements 36 zumindest einer Gesamtbreite 50 der Flachleitung 12. Durch das Versteifungselement 36 können die Leiterbahnen auf einfache Art und Weise gleichzeitig in Bezug zu den Kontaktpartner ausgerichtet werden, wodurch der Herstellungsprozess der elektrische Verbindung gut automatisierbar und zugleich zu sicher reproduzierbaren Kontaktierungsergebnissen führt.

Sowohl das Versteifungselement 36 als auch die Klebeschicht 38 und obere Isolierschicht 14 werden von der Laserstrahlung 40 nahezu verlustfrei durchsetzt. Zwischenräume 52 zwischen den Kupferleiterbahnen der flexiblen Flachleitung 12 können, in Abhängigkeit von einer Materialstärke der Leiterbahnen und/oder der Isolierschichten 14, 16 sowie der Klebeschichten 22, 24 der Flachleitung 12, beispielsweise mit demselben Material wie die Klebeschichten 22, 24 oder mit einem anderen elektrisch isolierenden Kunststoffmaterial, aufgefüllt sein.

Um eine verbesserte Widerstandsfähigkeit der solchermaßen aufgebauten elektrischen Verbindung 20 gegenüber schädlichen Umgebungseinflüssen, zum Beispiel starken Temperaturschwankungen, Feuchtigkeit, hohen mechanischen Beschleunigungen oder Verzögerungen sowie chemisch aggressiven Fluiden, zu schaffen, kann zwischen den metallischen Kontaktpartnern und der unteren Isolierschicht 16 eine Füllmasse aus einem geeigneten, elektrisch isolierendem Kunststoffmaterial eingebracht bzw. eingegossen oder eingespritzt werden (so genanntes "Molding").

Im weiteren Fortgang der Beschreibung soll der Ablauf des erfindungsgemäßen Verfahrens anhand der Figur 1 näher beschrieben werden.

In einem ersten Verfahrensschritt wird zunächst die Ausnehmung 30 in der unteren Isolierschicht 16 und der zugehörigen Klebeschicht 24 geschaffen. Dies kann bereits während des Herstellungsprozesses der flexiblen Flachleitung 12 erfolgen, indem in die untere Isolierschicht 16 vor dem Aufkleben derselben auf die Leiterbahnen Ausnehmungen mit der gewünschten geometrischen Gestalt eingestanzt werden. Hierbei wird diejenige Isolierschicht 14, 16 der Flachleitung 12 mit der Ausnehmung 30 versehen, auf deren Seite der metallische Kontaktpartner 18 thermisch angefügt werden soll. Im anschließenden Verfahrensschritt wird das Versteifungselement 36 mittels der Klebeschicht 38 bevorzugt vollflächig im Bereich der Fügezone 26 aufgeklebt, wodurch die im Übrigen flexible Flachleitung 12 im Bereich der Fügezone 26 eine "starre" Platte darstellt. Alternativ kann das Aufkleben des Versteifungselementes 36 gleichfalls während des Fertigungsprozesses der flexiblen Flachleitung 12 erfolgen. Das Aufbringen des Versteifungselementes 36 sollte vorzugsweise jedoch erst nach dem Einbringen der erforderlichen Ausnehmungen und dem nachfolgenden Aufkleben der beiden Isolierschichten auf die Leiterbahnen zur Fertigstellung der flexiblen Flachleitung 12 erfolgen. Das Versteifungselement 36 verbleibt nach der Beendigung des Verfahrens auf der Flachleitung und bildet einen effektiven Schutz gegen mechanische Beschädigungen der Leiterbahnen.

In einem dritten Verfahrensschritt erfolgt das Ausrichten des mit der Leiterbahn 10 elektrisch zu kontaktierenden metallischen Kontaktpartners 18 mittels des Versteifungselements 36. Um eine optimale elektrische Verbindung durch Laserfügen zu erzielen, ist es während des Fügeprozesses notwendig, die Stirnfläche 28 des metallischen Kontaktpartners 18 möglichst vollflächig an einer nicht bezeichneten Unterseite der Leiterbahn 10 anliegen zu lassen. Durch das aufgeklebte Versteifungselement 36 können in vorteilhafter Weise sämtliche in der Flachleitung 12 enthaltenen Leiterbahnen in Relation zu einer korrespondierenden Anzahl von Kontaktpartnern zeitgleich präzise, insbesondere parallel zur Zentralachse 42 ausgerichtet werden.

Im vierten Verfahrensschritt erfolgt das thermische Zusammenfügen der Leiterbahn 10 und der Stirnfläche 28 des metallischen Kontaktpartners 18 durch das Einstrahlen von Laserstrahlung 40 in die Fügezone 26, die sowohl das Versteifungselement 36 als auch die Klebeschicht 38 einschließlich der oberen Isolierschicht 14 durchsetzt.

Demzufolge müssen sowohl das Versteifungselement 36, als auch zumindest die obere Isolierschicht 14 einschließlich der Klebeschicht 38 mit einem Kunststoffmaterial gebildet sein, das die verfahrensgemäß benutzte Laserstrahlung 40 weitgehend verlustfrei passieren bzw. durchdringen kann.

Wie umfangreiche praktische Versuche ergeben haben, werden mit einer Laserenergie zwischen 5 J und 25 J und einer Einwirkzeit zwischen 1 ms und 10 ms optimale elektrische Verbindungen erzielt. Die Laserstrahlung 40 wird bevorzugt mit einem so genannten ND:YAG-Laser mit einer Leistung zwischen 1 kW und 5 kW erzeugt. Die Verwendung dieses Lasertyps hat gegenüber ansonsten in der Industrie vielfach eingesetzten CO₂-Lasern insbesondere den Vorteil, dass eine relativ kurzwellige Laserstrahlung erzeugbar ist, die über eine Vielzahl von Lichtwellenleitern punktgenau in die Fügezone 26 leitbar ist. Somit lassen sich problemlos metallische Kontaktpartner, insbesondere in der Form von Kontaktstiften, mit einem Durchmesser von wenigen Zehntelmillimetern mit entsprechend breiten Kupferleiterbahnen in einer Flachleitung thermisch fügen.

## Patentansprüche

1. Verfahren zur Herstellung einer elektrischen Verbindung (20) zwischen einer flexiblen Flachleitung (12) mit einer Vielzahl von Leiterbahnen (10), die zwischen zwei Isolierschichten (14, 16) angeordnet sind, und mindestens einem metallischen Kontaktpartner (18), insbesondere mindestens einem Kontaktstift, mit einer Stirnfläche (28), wobei mindestens eine Ausnehmung (30) in die Isolierschicht (16) im Bereich mindestens einer Fügezone (26) eingebracht wird, **gekennzeichnet durch** folgende Schritte:
a) Aufbringen mindestens eines für Laserstrahlung (40) durchgängigen Versteifungselements (36) auf die gegenüberliegende Isolierschicht (14) im Bereich der mindestens einen Fügezone (26) zur mechanischen Stabilisierung,
b) Positionieren mindestens einer Leiterbahn (10) mittels des mindestens einen Versteifungselements (36) in Relation zur Stirnfläche (28) mindestens eines Kontaktpartners (18), und
c) Thermisches Fügen, insbesondere Schweißen oder Löten, der mindestens einen Leiterbahn (10) und des mindestens einen Kontaktpartners (18) **durch** Laserstrahlung (40), wobei die Laserstrahlung (40) das Versteifungselement (36) durchsetzt.

2. Verfahren nach Anspruch 1, wobei das thermische Fügen derart ausgeführt wird, dass zwischen der mindestens einen Leiterbahn (10) und dem mindestens einen Kontaktpartner (18) eine elektrisch leitende und mechanisch belastbare Verbindung entsteht.

3. Verfahren nach Anspruch 1 oder 2, wobei das Versteifungselement (36) im Wesentlichen plattenförmig ausgestaltet ist und mittels eines Acryl- oder Epoxidklebers aufgeklebt wird.

4. Verfahren nach einem der Ansprüche 1 bis 3, wobei die mindestens eine Leiterbahn (10) vor dem thermischen Fügen mittels des Versteifungselements (36) gleichzeitig in Relation zu der mindestens einen Stirnfläche (28) des mindestens einen Kontaktpartners (18) ausgerichtet wird.

5. Verfahren nach einem der Ansprüche 1 bis 4, wobei das thermische Fügen mit einer Laserenergie von jeweils 5 J bis 25 J und einer Einwirkzeit zwischen 1 ms und 10 ms erfolgt, wobei insbesondere ein ND:YAG-Laser mit einer Leistung zwischen 1 kW und 5 kW verwendet wird.

6. Verfahren nach Anspruch 1, **dadurch gekennzeichnet, dass** die Isolierschicht (16) im Bereich der mindestens einen Fügezone (26) vollständig von der oder den Leiterbahnen (10) entfernt wird.

7. Elektrische Verbindung (20) zwischen einer flexiblen Flachleitung (12) mit einer Vielzahl von Leiterbahnen (10), die zwischen zwei Isolierschichten (14, 16) angeordnet sind, und mindestens einem metallischen Kontaktpartner (18), insbesondere mindestens einem Kontaktstift, mit einer Stirnfläche (28) wobei die eine Isolierschicht (16) im Bereich mindestens einer Fügezone (26) eine Ausnehmung (30) aufweist und mindestens eine Leiterbahn (10) in der mindestens einen Fügezone (26) mit dem mindestens einen metallischen Kontaktpartner (18) zur Herstellung einer elektrischen Verbindung (20) thermisch gefügt, insbesondere laserverschweißt oder laserverlötet, ist, **dadurch gekennzeichnet, dass** im Bereich der mindestens einen Fügezone (26) zumindest ein Versteifungselement (36) mit der gegenüberliegenden Isolierschicht (14) verbunden ist.

8. Elektrische Verbindung (20) nach Anspruch 7, wobei die Verbindung zwischen dem Versteifungselement (36) und der anderen Isolierschicht (14) zumindest bereichsweise durch eine Klebeschicht (38) erfolgt.

9. Elektrische Verbindung (20) nach Anspruch 7 oder 8, wobei das Versteifungselement (36) plattenförmig ist.

10. Elektrische Verbindung (20) nach einem der Ansprüche 7 bis 9, wobei das mindestens eine Versteifungselement (36) für Laserstrahlung (40) durchlässig ist.

## Claims

1. Method for producing an electrical connection (20) between a flexible flat line (12), having a large number of conductor tracks (10) which are arranged between two insulating layers (14, 16), and at least one metal contact partner (18), in particular at least one contact pin, having an end face (28), wherein at least one recess (30) is made in the insulating layer (16) in the region of at least one joining zone (26), **characterized by** the following steps:
a) applying at least one reinforcement element (36), through which laser radiation (40) can pass, to the opposite insulating layer (14) in the region of the at least one joining zone (26) for mechanical stabilization,
b) positioning at least one conductor track (10) in relation to the end face (28) of at least one contact partner (18) by means of the at least one reinforcement element (36), and
c) thermally joining, in particular welding or soldering, the at least one conductor track (10) and the at least one contact partner (18) by laser radiation (40), wherein the laser radiation (40) passes through the reinforcement element (36).

2. Method according to Claim 1, wherein the thermal joining is performed in such a way that an electrically conductive connection which can be mechanically loaded is produced between the at least one conductor track (10) and the at least one contact partner (18).

3. Method according to Claim 1 or 2, wherein the reinforcement element (36) is designed substantially in the form of a plate and is adhesively bonded by means of an acrylic or epoxy adhesive.

4. Method according to one of Claims 1 to 3, wherein the at least one conductor track (10), before the thermal joining, is simultaneously oriented in relation to the at least one end face (28) of the at least one contact partner (18) by means of the reinforcement element (36).

5. Method according to one of Claims 1 to 4, wherein the thermal joining is performed with a laser energy of in each case 5 J to 25 J and an action time of between 1 ms and 10 ms, wherein, in particular, an ND:YAG laser with a power of between 1 kW and 5 kW is used.

6. Method according to Claim 1, **characterized in that** the insulating layer (16) is completely removed from the conductor track or conductor tracks (10) in the region of the at least one joining zone (26).

7. Electrical connection (20) between a flexible flat line (12), having a large number of conductor tracks (10) which are arranged between two insulating layers (14, 16), and at least one metal contact partner (18), in particular at least one contact pin, having an end face (28), wherein one insulating layer (16) has a recess (30) in the region of at least one joining zone (26) and thermally joins, in particular laser-welds or laser-solders, at least one conductor track (10) to the at least one metal contact partner (18) in the at least one joining zone (26) in order to produce an electrical connection (20), **characterized in that** at least one reinforcement element (36) is connected to the opposite insulating layer (14) in the region of the at least one joining zone (26).

8. Electrical connection (20) according to Claim 7, wherein the connection between the reinforcement element (36) and the other insulating layer (14) is made by an adhesive layer (38) at least in regions.

9. Electrical connection (20) according to Claim 7 or 8, wherein the reinforcement element (36) is in the form of a plate.

10. Electrical connection (20) according to one of Claims 7 to 9, wherein the at least one reinforcement element (36) is permeable to laser radiation (40).

## Revendications

1. Procédé de fabrication d'une connexion électrique (20) entre un câble plat (12) flexible doté d'une pluralité de pistes conductrices (10) disposées entre deux couches isolantes (14, 16) et au moins un partenaire de contact (18) métallique, notamment au moins un pointeau de contact, avec une surface avant (28), au moins un évidement (30) étant réalisé dans la couche isolante (16), dans la région d'au moins une zone de jointement (26), **caractérisé par** les étapes suivantes :
a) application d'au moins un élément de renforcement (36) traversant pour rayonnement laser (40) sur la couche isolante (14) opposée se situant dans la région de l'au moins une zone de jointement (26), à des fins de stabilisation mécanique ;
b) positionnement d'au moins une piste conductrice (10) à l'aide de l'au moins un élément de renforcement (36) en relation avec la surface avant (28) d'au moins un partenaire de contact (18) ; et
c) assemblage thermique, notamment soudure ou brasage, de l'au moins une piste conductrice (10) et de l'au moins un partenaire de contact (18) par rayonnement laser (40), l'élément de renforcement (36) permettant de faire aboutir le rayonnement laser (40).

2. Procédé selon la revendication 1, l'assemblage thermique étant réalisé de telle sorte qu'une connexion électriquement conductrice et chargeable de façon mécanique est créée entre l'au moins une piste conductrice (10) et l'au moins un partenaire de contact (18).

3. Procédé selon la revendication 1 ou 2, l'élément de renforcement (36) prenant pour l'essentiel une forme de plaque et étant collé à l'aide d'une colle acryle ou époxy.

4. Procédé selon l'une quelconque des revendications 1 à 3, l'au moins une piste conductrice (10) étant orientée, avant l'assemblage thermique, à l'aide de l'élément de renforcement (36), simultanément en relation avec l'au moins une surface avant (28) de l'au moins un partenaire de contact (18).

5. Procédé selon l'une quelconque des revendications 1 à 4, l'assemblage thermique se produisant avec une énergie de laser de respectivement 5 J à 25 J et sur une durée d'action comprise entre 1 ms et 10 ms, un laser ND:YAG d'une puissance comprise entre 1 kW et 5 kW étant notamment utilisé.

6. Procédé selon la revendication 1, **caractérisé en ce que** la couche isolante (16) est entièrement retirée de la ou des pistes conductrices (10) dans la région de l'au moins une zone de jointement (26).

7. Connexion électrique (20) entre un câble plat (12) flexible avec une pluralité de pistes conductrices (10) disposées entre deux couches isolantes (14, 16) et au moins un partenaire de contact (18) métallique, notamment au moins un pointeau de contact, avec une surface avant (28), la couche isolante (16) située dans la région d'au moins une zone de jointement (26) comportant un évidement (30) et au moins une piste conductrice (10) prévue dans l'au moins une zone de jointement (26) avec l'au moins un partenaire de contact (18) métallique en vue de réaliser une connexion électrique (20) assemblée thermiquement, notamment soudée par laser ou brasée par laser, **caractérisée en ce qu'**au moins un élément de renforcement (36) est relié à la couche isolante (14) opposée dans la région de l'au moins une zone de jointement (26).

8. Connexion électrique (20) selon la revendication 7, la connexion entre l'élément de renforcement (36) et l'autre couche isolante (14) se produisant, dans certaines zones au moins, par adjonction d'une couche de colle (38).

9. Connexion électrique (20) selon la revendication 7 ou 8, l'élément de renforcement (36) prenant une forme de plaque.

10. Connexion électrique (20) selon l'une quelconque des revendications 7 à 9, l'au moins un élément de renforcement (36) étant perméable au rayonnement laser (40).
